# EUROPÄISCHE PATENTANMELDUNG

(11) **EP 4 542 318 A1**
(43) Veröffentlichungstag der Anmeldung: **23.04.2025**
(21) Anmeldenummer: 23204669.8
(22) Anmeldetag: 19.10.2023
(51) Int. Cl.: G05B 19/418

(54) **VERFAHREN ZUR AUSWAHL VON PRODUKTIONSLINIEN FÜR EINE PRODUKTIONSAUFGABE**

(71) Anmelder: Siemens Aktiengesellschaft, 80333 München (DE)
(72) Erfinder: Jeske, Nora, 10555 Berlin (DE); Müller, Bernd, 16259 Falkenberg (DE); Raab, Oliver, 94496 Ortenburg (DE); Sommerfeld, Dennis, 12347 Berlin (DE); Wittreich, Ulrich, 16727 Velten (DE)
(74) Vertreter: Siemens Patent Attorneys

(57) **Zusammenfassung**

Es wird ein Verfahren zur Auswahl von Produktionslinien für eine Produktionsaufgabe vorgeschlagen, wobei ein Auswahlsystem (10) einen Algorithmus nutzt, wobei der Algorithmus wenigstens einen Prozessparameter (PP) als Eingabewert spezifisch zur Produktionslinie (3), eine dazugehörige Parametergewichtung (PG) und als Ausgabewert eine Kennzahl (KZ) umfasst, wobei der jeweilige Prozessparameter (PP) kontinuierlich aktualisiert wird und in eine zyklische Ausführung des Algorithmus (11) wenigstens ein kontinuierlich aktualisierter Prozessparameter (PP) eingeht, wobei durch das Auswahlsystem (10) eine Aktualisierung der Auswahl erfolgt und eine korrespondierende Prozessmaßnahme automatisiert eingeleitet wird.

## Beschreibung

Die Erfindung betrifft ein Verfahren zur Auswahl von Produktionslinien für eine Produktionsaufgabe gemäß dem Oberbegriff des Patentanspruches 1.

Produktionslinien, insbesondere in der Elektronikfertigung werden je nach Auftragslage unterschiedlich intensiv genutzt und ihr Betrieb kann hinsichtlich der Kenngrößen wie Produktionsdurchsatz, Termintreue oder Energieeffizienz abgestimmt werden.

Durch eine wechselnde Auftragslage ergeben sich Stillstandzeiten in denen die jeweilige Produktionslinie entweder in einen Standby-Betrieb versetzt oder komplett ausgeschaltet wird und die erneute Zuschaltung kann automatisch über eine Zeitschaltuhr erfolgen.

Innerhalb eines schichtweisen Betriebs der Produktionslinien ergeben sich zusätzliche Stillstandzeiten durch Wartungsarbeiten, Rüstwechsel und Pausen der Maschinenbediener, bei denen insbesondere energieintensive Maschinen wie zum Beispiel Lötanlagen weiterlaufen.

Eine weitere Quelle für Stillstandzeiten sind Programmwechsel, welche ein Aufheizen oder Abkühlen der Maschinen innerhalb einer Produktionslinie bedingen.

Stillstandzeiten können zu einer Verringerung eines Produktionsdurchsatzes oder einer Verschlechterung einer Termintreue führen, ferner kann ein wenig selektiver Betrieb einzelner energieintensiver Maschinen zu einer schlechteren Energieeffizienz der Gesamtanlage führen.

Der vorliegenden Erfindung liegt die Aufgabe zugrunde, die Auswahl einzelner Produktionslinien hinsichtlich Durchsatzmaximierung, Energieeffizienz und/oder Termintreue der Gesamtproduktion zu verbessern.

Die Aufgabe wird durch ein Verfahren mit den Merkmalen des unabhängigen Patentanspruches 1 gelöst. In den abhängigen Patentansprüchen sind vorteilhafte Ausgestaltungen und Weiterbildungen der Erfindung angegeben.

Das erfindungsgemäße Verfahren zur Auswahl von Produktionslinien für eine Produktionsaufgabe, erfolgt durch ein Auswahlsystem welches einen Algorithmus nutzt, wobei der Algorithmus wenigstens einen Prozessparameter als Eingabewert spezifisch zur Produktionslinie, eine dazugehörige Parametergewichtung und als Ausgabewert eine Kennzahl umfasst, wobei der jeweilige Prozessparameter kontinuierlich aktualisiert wird und in eine zyklische Ausführung des Algorithmus wenigstens ein kontinuierlich aktualisierter Prozessparameter eingeht, wobei durch das Auswahlsystem eine Aktualisierung der Auswahl erfolgt und eine korrespondierende Prozessmaßnahme automatisiert eingeleitet wird.

Die Produktionslinie setzt sich aus einer Menge einzelner Maschinen und/oder Prozessschritte zusammen.

Das Auswahlsystem umfasst einzelne Regeln und/oder einen mehrstufigen Algorithmus, welcher auf Basis von Prozessparametern als Eingabewerte und Parametergewichtungen, eine Kennzahl, insbesondere eine Priorität für einzelne Produktionslinien festlegen kann.

Die Priorität bildet eine dimensionslose Kennzahl, mit welcher die einzelnen Produktionslinien hinsichtlich Ihrer Eignung für bestimmte Produktionsstrategien verglichen werden können. Insbesondere kann die Priorität einer Produktionslinie aus Sicht eines Graphenmodells aus den spezifischen Pfadkosten abgeleitet werden.

Zur Beeinflussung der Prioritäten werden die Parametergewichte abhängig zu einer gewünschten Produktionsstrategie und einem anstehenden Auftrag ausgewählt. Die Auswahl der Parametergewichte kann die Festlegung der Prioritäten durch den Algorithmus beeinflussen.

In anderen Worten können die vorliegenden Produktionslinien, bei demselben anstehenden Auftrag, unter der Parametergewichtung der Produktionsstrategie "Energieeffizienz" andere Prioritäten erhalten als unter der Parametergewichtung der Produktionsstrategie "Durchsatzmaximierung".

Die Prozessparameter stellen Eingabegrößen für die Festlegung der Prioritäten einzelner Produktionslinien dar. Die einzelnen Prozessparameter können mittels Parametergewichte eine Gewichtung erhalten.

Die Parametergewichtung stellt einen dimensionslosen Wert dar, welcher abhängig zur gewünschten Produktionsstrategie ausgewählt wird und dem dazugehörigen Parameter im Algorithmus eine höhere oder niedrigere Gewichtung oder auch Einfluss zukommen lässt.

Die Produktionsaufgabe umfasst die Produktion eines Gutes und kann hierfür aus einem mehrstufigen Prozess aus Prozessmaßnahmen bestehen.

In anderen Worten stellt die Prozessmaßnahme wenigstens einen Schritt einer Produktionsaufgabe dar.

Die Produktionsstrategie bildet ein der Produktionsaufgabe übergeordnetes Ziel ab, insbesondere kann die Erhöhung der Energieeffizienz, die Durchsatzmaximierung oder eine verkürzte Fertigungszeit Ziel einer Produktionsstrategie sein.

Der Algorithmus stellt eine Vorschrift dar, mit dessen Hilfe die Festlegung der jeweiligen Priorität, insbesondere für eine Produktionslinie erfolgt.

Durch die vorliegende Erfindung wird vorteilhafterweise die Implementierung von spezifischen Produktionsstrategien ermöglicht. Das ist deshalb der Fall, weil die jeweilige Produktionsstrategie durch höhere Parametergewichte für die spezifischen Stellgrößen im Auswahlsystem berücksichtigt wird.

Gemäß einer vorteilhaften Ausgestaltung kann das Auswahlsystem einen Dijkstra-Algorithmus nutzen.

Die Modellierung von Produktionslinien als kantengewichteter Graph ermöglicht vorteilhafterweise den Einsatz des Dijkstra-Algorithmus und/oder anderer leistungsfähiger Algorithmen aus dem Bereich der Graphentheorie, insbesondere für die Auswahl einer Produktionslinie für eine Produktionsaufgabe.

Der Dijkstra-Algorithmus ist ein Vertreter der Greedy-Algorithmen und umfasst die Festlegung eines Pfades mit der kürzesten Länge zwischen einem Startknoten und Zielknoten in einem kantengewichteten Graphen.

Die Länge eines Pfades kann sich anhand verschiedener Metriken bemessen, insbesondere die Anzahl der Knoten innerhalb eines Pfades und/oder die spezifischen Pfadkosten bestehend aus Knotenkosten und Kantengewichten können hierbei betrachtet werden. Der kürzeste Pfad in einem Graphenmodell zeichnet sich durch die geringsten Pfadkosten für die Erreichung eines Zielknotens, ausgehend von einem Startknoten, aus.

Die Pfadkosten in einem Graphenmodell umfassen eine dimensionslose Darstellung von Kosten für die Erreichung eines Zielknotens ausgehen von einem Startknoten. Für die Festlegung von Pfadkosten kann insbesondere die Summe der Produkte aus Knotenkosten und dem Kantengewicht KG der in den jeweiligen Knoten eingehenden Kante, die gemeinsam einen spezifischen Pfad beschreiben, herangezogen werden.

Die Knotenkosten für einen jeweiligen Knoten können mittels der vorliegenden Prozessparameter und Parametergewichte festgelegt werden.

In einer vorteilhaften Weiterbildung der Erfindung kann das Auswahlsystem einen A*-Algorithmus, als Erweiterung des Dijkstra-Algorithmus um ein heuristisches Modell, nutzen.

Dadurch ist es vorteilhafterweise möglich die Auswahl kurzer Pfade zu verstärken, indem gemäß dem heuristischen Modell zusätzliche Informationen für die Auswahl einer Produktionslinie einbezogen werden können.

Ein Beispiel hierfür kann die Berücksichtigung einer erfahrungsgemäß langen Abkühlzeit einer Maschine sein, sodass diese als Knoten für Aufträge mit geringen Temperaturbedarf höhere Knotenkosten durch den Algorithmus erhält.

Der A*-Algorithmus ist ein Vertreter der informierten Suchalgorithmen und gilt als Erweiterung des Dijkstra-Algorithmus. Der Algorithmus dient der Festlegung des kürzesten Pfades zwischen zwei Punkten und zeichnet sich zusätzlich dadurch aus, dass mittels einer Heuristik bestimmte Knoten, die wahrscheinlich schneller zum Ziel führen zuerst berücksichtig werden.

Das heuristische Modell umfasst Erfahrungswerte und/oder allgemeine Informationen zur Produktionslinie und/oder realistische Annahmen. Hierzu kann das Modell insbesondere als ein Satz an Wenn-dann-Regeln ausgeprägt sein.

Gemäß einer vorteilhaften Ausgestaltung kann eine Betriebstemperatur einer Lötanlage bei der Auswahl der Produktionslinie als ein Parameter im Auswahlsystem abgebildet werden.

Dadurch ist es vorteilhafterweise möglich die Auswahl einer Produktionslinie unter Rücksichtnahme der nötigen Zeit und/oder Energie für ein Aufheizen der Lötanalage vorzunehmen und damit Zeit und Energiekosten einzusparen.

In einer Weiterbildung der Erfindung kann eine Rüstzeit für eine Bestückungsmaschine bei der Auswahl der Produktionslinie als ein Parameter im Auswahlsystem abgebildet werden.

Dadurch ist es vorteilhafterweise möglich die Auswahl einer Produktionslinie unter Rücksichtnahme der nötigen Rüstzeit für eine jeweilige Bestückungsmaschine vorzunehmen und damit Zeit einzusparen.

Gemäß einer vorteilhaften Ausgestaltung kann ein Liefertermin für ein Gut bei der Auswahl der Produktionslinie als ein Parameter im Auswahlsystem abgebildet werden.

Dadurch ist es vorteilhafterweise möglich die Auswahl einer Produktionslinie unter Rücksichtnahme eines feststehenden Liefertermins vorzunehmen und damit eine deterministische Abarbeitung der Produktionsaufgaben sicherzustellen.

In einer Weiterbildung der Erfindung kann eine Restlaufzeit eines laufenden Auftrags auf einer Produktionslinie bei der Auswahl der Produktionslinie als ein Parameter im Auswahlsystem abgebildet werden.

Dadurch ist es vorteilhafterweise möglich die Stillstandzeit einer Produktionslinie bei einem Übergang zwischen zwei verschiedenen Produktionsaufgaben zu verringern.

Gemäß einer vorteilhaften Ausgestaltung kann ein geplanter Stillstand der Produktionslinie bei der Auswahl der Produktionslinie als ein Parameter im Auswahlsystem abgebildet werden.

Dadurch ist es vorteilhafterweise möglich die in Kürze von einem Stillstand betroffene Produktionslinie oder deren Abschnitte aus dem Algorithmus auszuschließen und damit den Auswahlprozess durch das Auswahlsystem zu beschleunigen.

In einer vorteilhaften Weiterbildung der Erfindung kann die Auswahl für einzelne Maschinen produktionslinienübergreifend festgelegt werden.

Dadurch kann die Prioritätsfestlegung granular zwischen Produktionslinienebene und Maschinenebene eingestellt werden, insbesondere durch eine Priorisierung auf Maschinenebene kann dadurch ein nötiger Wechsel der Produktionslinie schneller eingeleitet werden.

Gemäß einer vorteilhaften Ausgestaltung kann, die vom Auswahlsystem getroffene Zuweisung der Produktionsaufgabe zu einer Produktionslinie durch das Anzeigegerät angezeigt werden.

Dadurch können Anlagenbetreiber und/oder Maschinenbediener die festgelegte Priorisierung ohne zusätzliche Ausrüstung oder Schnittstellen ablesen und eine schnelle Reaktion auf Fehler wird ermöglicht.

Weitere Vorteile, Merkmale und Einzelheiten der Erfindung ergeben sich aus den im Folgenden beschriebenen Ausführungsbeispielen sowie anhand der Zeichnungen. Dabei zeigen schematisiert:
Figur 1 ein Ausführungsbeispiel für eine Produktionslinie 3, als Graphenmodell;
Figur 2 ein Ausführungsbeispiel für drei Produktionslinien 3 als Graphenmodell;
Figur 3 ein Ausführungsbeispiel für drei Produktionslinien 3 als Graphenmodell mit einem einheitlichen Kantengewicht KG, spezifischen Knotenkosten KK und einer Vernetzung mehrerer Produktionslinien durch die Kanten 2 ***̅B̅*̅₂̅*̅C̅*̅₁̅** und ***̅B̅*̅₂̅*̅C̅*̅₃̅**; und
Figur 4 ein Ausführungsbeispiel für drei Produktionslinien 3 als Graphenmodell mit kantenspezifischen Kantengewichten KG, knotenspezifischen Knotenkosten KK und einer Vernetzung mehrerer Produktionslinien durch die Kanten 2 ***̅B̅*̅₂̅*̅C̅*̅₁̅** und ***̅B̅*̅₂̅*̅C̅*̅₃̅;**
Figur 5 zeigt ein Flussdiagramm für ein Auswahlsystem, welches die Ausführung des Algorithmus, die Aktualisierung der Auswahl und die Einleitung einer Prozessmaßnahme umfasst.

Gleichartige, gleichwertige oder gleichwirkende Elemente können in einer der Figuren oder in den Figuren mit denselben Bezugszeichen versehen sein.

Die folgenden Figurenbeschreibungen nutzen eine in diesem Abschnitt beschriebene gemeinsame Notation für Elemente des Graphenmodells und Berechnungsvorschriften. Für einem jeweiligen Knoten 1 wird eine Station und/oder Maschine einer typischen Elektronikfertigung durch einen Buchstaben A, B, C oder D zugeordnet und durch einen Index 1, 2 oder 3 einer jeweiligen Produktionslinie 3 zugeordnet, insbesondere als ***A*₁*.*** Die Notation A bezeichnet einen Schablonendruck, B einen Bestückungsautomaten, C eine Lötanlage und D eine Qualitätsprüfung. Für die Knotenkosten ***KK*** eines Knotens wird als Index der jeweilige Knotenname verwendet, insbesondere als ***KK*_{*A*1}***.* Die für einen Knoten 1 spezifischen Knotenkosten ***KK*** können als Produkt aus den knotenspezifischen Prozessparameter ***PP*** und Parametergewicht ***PG*** berechnet werden. Die Kanten 2 werden anhand Ihres Startknotens und Endknotens benannt, insbesondere ***̅A̅*̅₁̅*̅B̅*̅₁̅** für eine Kante die die Knoten ***A*₁** und ***B*₁** verbindet. Der Startpunkt 0 ist kein Knoten 1 und vom Startpunkt 0 ausgehende Kanten 2 werden mit dem anführenden Buchstaben "S" bezeichnet, insbesondere als ***̅S̅A̅*̅₁̅** für eine Kante 2 die den Startpunkt 0 mit dem Knoten 1 ***A*₁** verbindet. Einer Kante kann ein Kantengewicht ***KG*** zugeordnet werden.

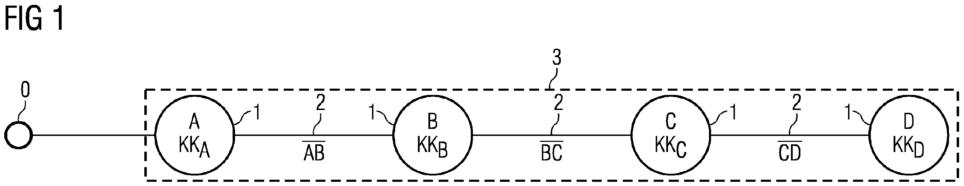

Die Figur 1 zeigt ein Graphenmodell für eine Produktionslinie 3 mit dem Startpunkt 0 gemäß Ausführungsbeispiel. Die Produktionslinie 3 ist hierbei durch eine gestrichelte Linie als Bereich abgegrenzt. Die Produktionslinie 3 umfasst eine Kaskadierung aus den Knoten 1 A, B, C und D, wobei jeder Knoten spezifische Knotenkosten ***KK*** besitzt und die Kaskade erzeugende Kanten jeweils ein Kantengewicht KG.

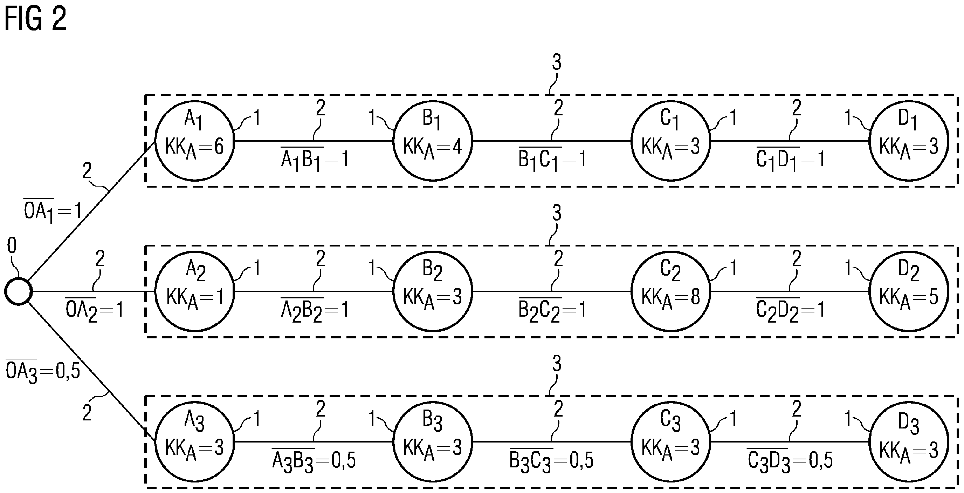

Die Figur 2 zeigt ein Graphenmodell für drei gekapselte Produktionslinien 3 mit dem gemeinsamen Startpunkt 0 gemäß einem Ausführungsbeispiel. Jede Produktionslinie 3 besteht aus einer Anzahl aus Knoten 1 und Kanten 2 mit jeweils einer spezifischen Kantengewichtung KG. Die Produktionslinien 3 sind hierbei jeweils durch eine gestrichelte Linie als Bereich abgegrenzt. Eine Produktionsaufgabe kann in diesem Graphenmodell als Pfad von Startpunkt 0 zu einem Knoten D der jeweiligen Produktionslinie 3 abgebildet werden.

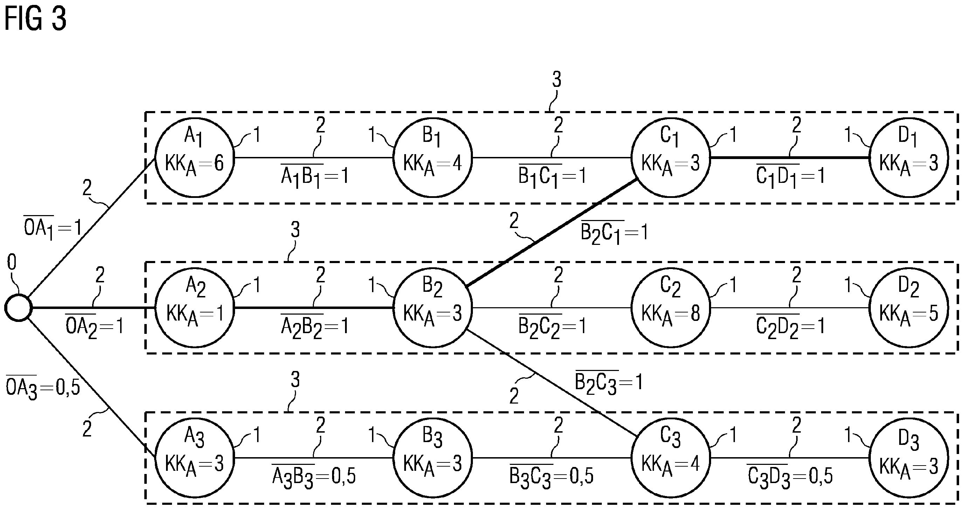

Die Figur 3 zeigt das Graphenmodell für drei gekoppelte Produktionslinien 3 mit dem gemeinsamen Startpunkt 0 gemäß einem Ausführungsbeispiel, wobei die Produktionslinien 3 über die Kanten 2 ***̅B̅*̅₂̅*̅C̅*̅₁̅** und ***̅B̅*̅₂̅*̅C̅*̅₃̅** miteinander gekoppelt sind.

Bei einer einheitlichen Kantengewichtung KG in Figur 3 wird anhand von beispielhaften Prozessparametern der Pfad mit den geringsten Kosten von Startpunkt 0 bis zu einem beliebigen Knoten D für eine Produktionsaufgabe, mit dickerer Linie, hervorgehoben.

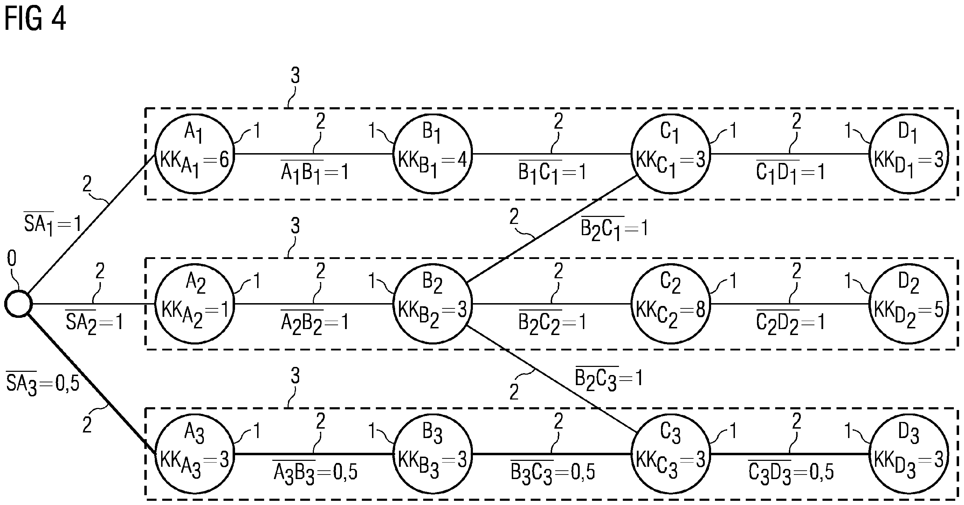

Die Figur 4 zeigt das Graphenmodell für drei gekoppelte Produktionslinien 3 mit dem gemeinsamen Startpunkt 0 gemäß einem Ausführungsbeispiel, wobei die Produktionslinien 3 über die Kanten ***̅B̅*̅₂̅*̅C̅*̅₁̅** und ***̅B̅*̅₂̅*̅C̅*̅₃̅** miteinander verbunden sind.

Bei einer spezifischen Kantengewichtung KG und spezifischen Prozessparametern PP in Figur 4 wird der Pfad mit den geringsten Kosten von Startpunkt 0 bis zu einem beliebigen Knoten 1 D für eine Produktionsaufgabe, mit dickerer Linie, hervorgehoben.

Die Pfadkosten für den kürzesten Pfad in Figur 4 betragen 6 und werden durch folgenden Term repräsentiert: ***̅S̅A̅*̅₃̅ * *KK*_{*A*3}** + ***̅A̅*̅₃̅*̅B̅*̅₃̅ * *KK*_{*B*3} + *̅B̅*̅₃̅*̅C̅*̅₃̅ * *KK*_{*C*3} + *̅C̅*̅₃̅*̅D̅*̅₃̅ * *KK*_{*D*3}** *=* ***Pfadkosten*.** Die Festlegung des Pfades mit den geringsten Kosten kann durch den Dijkstra-Algorithmus realisiert werden, hierbei werden die Kosten für einen möglichen Pfad, insbesondere wie im gezeigten Term durch das Auswahlsystem 10 festgelegt.

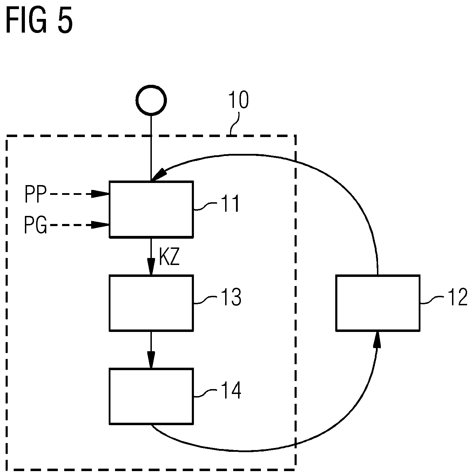

Die Figur 5 zeigt ein Flussdiagramm für das Auswahlsystem 10, welches die Ausführung des Algorithmus 11, die Aktualisierung der Auswahl 13 und die Einleitung einer Prozessmaßnahme 14 umfasst. Die zyklische Ausführung des Algorithmus 11 und des gesamten Auswahlsystems kann über den Verfahrensschritt 12 gesteuert werden, welcher durch ein statischen Zeitglied oder ein dynamischer Trigger abgebildet werden kann.

Obwohl die Erfindung im Detail durch die bevorzugten Ausführungsbeispiele näher illustriert und beschrieben wurde, so ist die Erfindung nicht durch die offenbarten Beispiele eingeschränkt oder andere Variationen können vom Fachmann hieraus abgeleitet werden, ohne den Schutzumfang der Erfindung zu verlassen.

### Bezugszeichenliste

- 0: Startpunkt
- 1: Knoten
- 2: Kante
- 3: Produktionslinie
- 10: Auswahlsystem
- 11: Ausführung Algorithmus
- 12: Statisches Zeitglied oder dynamischer Trigger
- 13: Aktualisierung der Auswahl
- 14: Einleitung einer Prozessmaßnahme
- KK: Knotenkosten
- PP: Prozessparameter
- PG: Parametergewichtung
- KG: Kantengewicht
- KZ: Kennzahl

## Patentansprüche

1. Verfahren zur Auswahl von Produktionslinien (3) für eine Produktionsaufgabe, **dadurch gekennzeichnet, dass** ein Auswahlsystem (10) einen Algorithmus nutzt, wobei der Algorithmus wenigstens einen Prozessparameter (PP) als Eingabewert spezifisch zur Produktionslinie (3), eine dazugehörige Parametergewichtung (PG) und als Ausgabewert eine Kennzahl (KZ) umfasst, wobei der jeweilige Prozessparameter (PP) kontinuierlich aktualisiert wird und in eine zyklische Ausführung des Algorithmus (11) wenigstens ein kontinuierlich aktualisierter Prozessparameter (PP) eingeht, wobei durch das Auswahlsystem (10) eine Aktualisierung der Auswahl erfolgt und eine korrespondierende Prozessmaßnahme automatisiert eingeleitet wird.

2. Verfahren gemäß Anspruch 1, **dadurch gekennzeichnet, dass** das Auswahlsystem (10) einen Dijkstra-Algorithmus nutzt.

3. Verfahren gemäß Anspruch 2, **dadurch gekennzeichnet, dass** bei dem Auswahlsystem (10) einen A*-Algorithmus, als Erweiterung des Dijkstra-Algorithmus um ein heuristisches Modell, genutzt wird.

4. Verfahren nach Anspruch 1 bis 3, **dadurch gekennzeichnet, dass** eine Betriebstemperatur einer Lötanlage bei der Auswahl der Produktionslinie (3) als ein Parameter im Auswahlsystem (10) abgebildet wird.

5. Verfahren nach Anspruch 1 bis 4, **dadurch gekennzeichnet, dass** eine Rüstzeit für eine Bestückungsmaschine bei der Auswahl der Produktionslinie (3) als ein Parameter im Auswahlsystem (10) abgebildet wird.

6. Verfahren nach Anspruch 1 bis 5, **dadurch gekennzeichnet, dass** ein Liefertermin für ein Gut bei der Auswahl der Produktionslinie (3) als ein Parameter im Auswahlsystem (10) abgebildet wird.

7. Verfahren nach Anspruch 1 bis 6, **dadurch gekennzeichnet, dass** eine Restlaufzeit eines laufenden Auftrags auf einer Produktionslinie (3) bei der Auswahl der Produktionslinie (3) als ein Parameter im Auswahlsystem (10) abgebildet wird.

8. Verfahren nach Anspruch 1 bis 7, **dadurch gekennzeichnet, dass** ein geplanter Stillstand der Produktionslinie (3) bei der Auswahl der Produktionslinie als ein Parameter im Auswahlsystem (10) abgebildet wird.

9. Verfahren gemäß Anspruch 1 bis 8, **dadurch gekennzeichnet, dass** die Auswahl für einzelne Maschinen produktionslinienübergreifend festgelegt wird.

10. Verfahren gemäß Anspruch 1 bis 3, **dadurch gekennzeichnet, dass** die vom Auswahlsystem (10) getroffene Zuweisung der Produktionsaufgabe zu einer Produktionslinie (3) durch das Anzeigegerät angezeigt wird.
